# EUROPEAN PATENT APPLICATION

(11) **EP 4 354 492 A1**
(43) Date of publication of application: **17.04.2024**
(21) Application number: 22820076.2
(22) Date of filing: 30.05.2022
(51) Int. Cl.: H01L 21/66, B23K 26/00

(54) **WAFER MARKING METHOD, NITRIDE SEMICONDUCTOR DEVICE MANUFACTURING METHOD, AND NITRIDE SEMICONDUCTOR SUBSTRATE**

(30) Priority: 08.06.2021 JP 2021095592
(71) Applicant: Shin-Etsu Handotai Co., Ltd., Tokyo 100-0004 (JP)
(72) Inventor: HAGIMOTO, Kazunori, Annaka-shi, Gunma 379-0196 (JP); GOTO, Shouzaburo, Tokyo 100-0004 (JP)
(74) Representative: Mooser, Sebastian Thomas
(86) International application number: PCT/JP2022/021848
(87) International publication number: WO 2022/259894

(57) **Abstract**

The present invention is a wafer marking method by using a laser for performing a laser marking on a defect region of a nitride semiconductor substrate in which a nitride semiconductor layer contains at least a GaN layer formed by epitaxial growth on a single-crystal silicon substrate. The method includes that a surface of the GaN layer and a surface of the single-crystal silicon substrate are performed laser marking simultaneously by irradiating the defect region with a laser of a wavelength within ±10% of 365 nm, having a wavelength corresponding to a band gap energy of GaN. This provides a wafer marking method for a laser marking on a defect region of a nitride semiconductor substrate in which a nitride semiconductor layer contains at least a GaN layer formed by epitaxial growth on a single-crystal silicon substrate, including a surface of the GaN layer and a surface of the single-crystal silicon substrate are performed laser marking to the defect region simultaneously.

## Description

### TECHNICAL FIELD

The present invention relates to a wafer marking method, a method of producing a nitride semiconductor device, and a nitride semiconductor substrate.

### BACKGROUND ART

A semiconductor substrate having a nitride semiconductor such as GaN for producing a device includes a nitride semiconductor layer forming on a single-crystal silicon substrate by epitaxial growth (heteroepitaxial growth). (Hereinafter, a heteroepitaxial substrate with such a structure is also called simply "a nitride semiconductor substrate".)

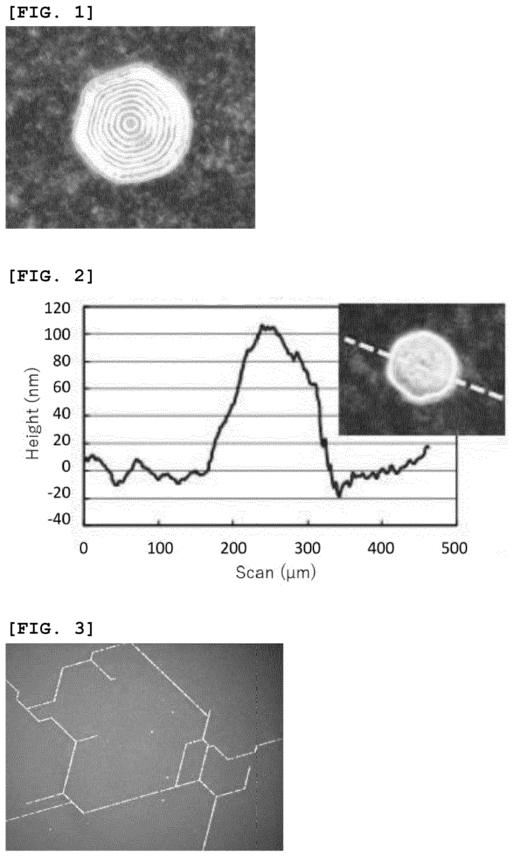

A pyramid-shaped defect may be generated when an epitaxial growth is performed on the single-crystal silicon substrate with GaN. (Hereinafter this defect is referred to as "a pyramid defect". This is a bump in reality and typically has a height of 100 to 200 nm and a diameter of 200 to 300 µm.) FIG. 1 shows an optical micrograph of the pyramid defect. FIG. 2 shows a cross-sectional shape of the pyramid defect. A graph in FIG. 2 illustrates a height profile of a scanned dashed line portion of an upper right image in FIG. 2. When there is the pyramid defect on a surface of the nitride semiconductor substrate in a device production process at a device manufacturer or other party, the device produced in the pyramid defect region is defective because of defocusing in the photolithography step, and device reliability cannot be guaranteed after device production.

In addition, a buffer layer is typically formed on the single-crystal silicon substrate by epitaxial growth with GaN. When an internal crack (see FIG. 3) exists due to a crack in the buffer layer during growth, such a place with the crack makes the device produced there also defective.

### CITATION LIST

### PATENT LITERATURE

Patent Document 1: JP 2003-142541 A

### SUMMARY OF INVENTION

### TECHNICAL PROBLEM

As a measure to meet these problems, laser marking is performed at a place where a defect such as a pyramid defect on a nitride semiconductor substrate or an internal crack exists (defect region). Such a laser marking is considered to enable the removal of a chip (a nitride semiconductor device) having a defect region in a step of a device production process, thus preventing an outflow of a defective product.

Patent document 1 discloses the marking by a laser marker around a particle detected by a particle counter as an example of the laser marking to a typical semiconductor wafer not limited to the nitride semiconductor substrate.

Incidentally, in the case of the laser marking to a semiconductor in general, a laser having a wavelength with higher energy (short wavelength) than a band gap of the semiconductor needs to be irradiated. However, when the laser has the wavelength with higher energy than the band gap of the semiconductor, the laser only melts a surface of the semiconductor and is unable to produce a leakage path detectable by an electrical measurement in an epitaxial layer itself, thus unable to remove the rejectable chip by an electric characteristics evaluation.

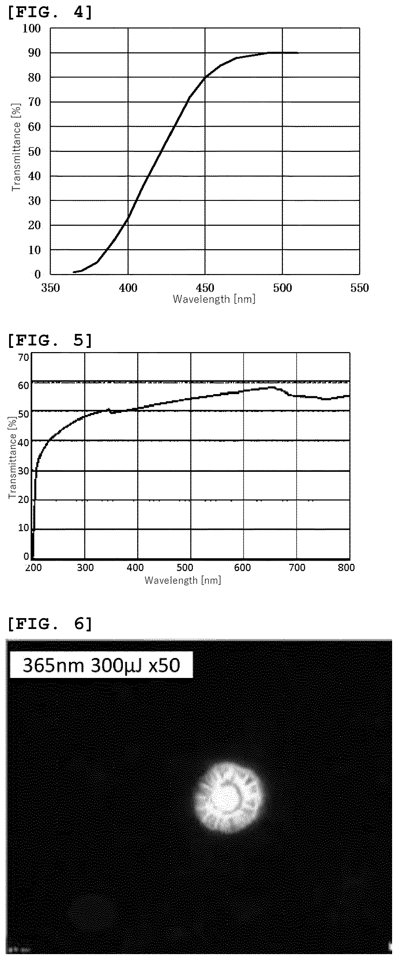

Moreover, when a laser having a wavelength of lower energy (long wavelength) than the band gap of the semiconductor is irradiated, the semiconductor is recognized as a transparent body thus laser light transmits through and reaches a ground substrate. The laser heats and melts the substrate and then a vapored gas bursts (explosion, blowing up) an epitaxial layer as a surface layer and scatters a fume around the marking. This is problematic. FIG. 4 illustrates the relations between the wavelength of laser light and transmittance to GaN. Additionally, FIG. 5 illustrates the relationship between a wavelength of a laser light and transmittance to AlN.

The present invention has been made in view of the above-described problem. An object of the present invention is to provide a laser marking method capable of simultaneously marking the surface of the GaN layer and the surface of the single-crystal silicon substrate when laser marking is performed to the defect region in the nitride semiconductor substrate on which a nitride semiconductor layer containing at least the GaN layer is formed by epitaxial growth on the single crystal silicon substrate.

### SOLUTION TO PROBLEM

To achieve the object, the present invention provides a wafer marking method by using a laser for performing a laser marking on a defect region of a nitride semiconductor substrate in which a nitride semiconductor layer contains at least a GaN layer formed by epitaxial growth on a single-crystal silicon substrate, wherein
a surface of the GaN layer and a surface of the single-crystal silicon substrate are performed laser marking simultaneously by irradiating the defect region with a laser of a wavelength within ±10% of 365 nm, having a wavelength corresponding to a band gap energy of GaN.

Such an inventive wafer marking method can perform marking simultaneously on the surface of the GaN layer and the surface of the single-crystal silicon substrate (an interface with the nitride semiconductor layer) by irradiating the defect region with a laser of a wavelength within ±10% of 365 nm (i.e., 328.5 to 401.5 nm), having a wavelength corresponding to a band gap energy of GaN. In this way, the marking on the surface of the single-crystal silicon substrate can form a leakage path in the vicinity of the interface. Such a formation of the leakage path can detect the defect region by an electric characteristics evaluation.

In this case, a wavelength of the laser performing the marking is preferably ±5% of 365 nm.

By irradiating the laser with a wavelength in the range closer to the band gap energy of GaN, the surface of the GaN layer surface and the surface of the single-crystal silicon substrate can be more reliably marked simultaneously.

In the inventive wafer marking method, the nitride semiconductor layer may include an AlN layer and an AlGaN layer in addition to the GaN layer.

AlN and AlGaN have a larger band gap energy than that of GaN and thus a laser having a wavelength corresponding to the band gap energy of GaN can transmit through the AlN layer as well as AlGaN layer and melt the surface and a vicinity area on the single-crystal silicon. Thus, the present invention is applicable to the nitride semiconductor layer made of not only the GaN layer but also the layers containing the AlN layer as well as the AlGaN layer.

In addition, the present invention provides a method of producing a nitride semiconductor device on a nitride semiconductor substrate comprising the steps of:
performing a laser marking on the nitride semiconductor substrate by the wafer marking method;
producing a plurality of nitride semiconductor devices on the laser-marked nitride semiconductor substrate; and
evaluating electrical characteristics of the nitride semiconductor substrate with a plurality of nitride semiconductor devices being produced then removing a nitride semiconductor device having the defect region by detecting a leakage path.

As aforementioned, the inventive wafer marking method can form the leakage path on the surface and vicinity of the single-crystal silicon substrate. Thus, the inventive method of producing the nitride semiconductor device can detect the defect region by the electric characteristics evaluation.

Moreover, the present invention provides a nitride semiconductor substrate having an epitaxial layer made of a nitride semiconductor layer containing at least a GaN layer on a single-crystal silicon substrate, in which a defect region of the nitride semiconductor substrate is laser marked, wherein
the laser mark is provided at a surface of the GaN layer and a surface of the single-crystal silicon substrate at an identical location in a plane, and a leakage path is formed at the laser-marked location on the single-crystal silicon substrate.

In such a nitride semiconductor substrate, the laser marking is performed at the identical location in a plane on the surface of the GaN layer and on the surface of the single crystal silicon substrate, and thus the leakage path is formed in the vicinity of the marked surface of the single crystal silicon. Consequently, the electric characteristics evaluation simplifies a removal of a chip with the defect region during a device production process.

Moreover, the present invention provides a method of producing a nitride semiconductor device on a nitride semiconductor substrate comprising the steps of:
producing a plurality of nitride semiconductor devices on the nitride semiconductor substrate; and
evaluating the electrical characteristics of the nitride semiconductor substrate with a plurality of nitride semiconductor devices being produced then removing a nitride semiconductor device having the defect region by detecting a leakage path.

In this way, the detection of the leakage path by the electric characteristics evaluation enables to removal of the chip having the defect region, thus a rejectable chip is removed very quickly. Therefore, the method of producing the nitride semiconductor device is advantageous in terms of productivity and production cost for the nitride semiconductor device.

### ADVANTAGEOUS EFFECTS OF INVENTION

The inventive wafer marking method can perform marking simultaneously on a surface of a GaN layer and a surface of a single-crystal silicon substrate (an interface with a nitride semiconductor layer) by irradiating the defect region with a laser of a wavelength within ±10% of 365 nm having a wavelength corresponding to a band gap energy of GaN. In this way, the marking on the surface of the single-crystal silicon substrate can form a leakage path in the vicinity of the interface. This allows the nitride semiconductor substrate to have the laser marking applied to the surface of the GaN layer and the surface of the single-crystal silicon substrate at an identical location in the plane. Moreover, the leakage path can be formed in the vicinity of the surface of a single-crystal silicon that is marked. Such a formation of the leakage path enables detection of a defect region by an electric characteristics evaluation. Furthermore, this enables the method of producing the nitride semiconductor device to remove the rejectable chip very quickly during the production process of the nitride semiconductor device, thus the method has an advantage in view of the producibility and production cost of the nitride semiconductor device. In addition, by using the laser of such a wavelength, such as a burst during the laser marking is suppressed, a generation of fume is suppressed, and then the surface is kept in a clean state.

### BRIEF DESCRIPTION OF DRAWINGS

FIG. 1 is an optical microscope showing a pyramid defect.
FIG. 2 is an optical microscope showing the pyramid defect and a graph showing a measurement result of a cross-sectional shape of the pyramid defect.
FIG. 3 is an optical microscope showing an internal crack that is formed when the buffer layer is cracked during growth.
FIG. 4 is a graph showing the relation between a wavelength of a laser and transmittance to GaN.
FIG. 5 is a graph showing the relation between the wavelength of the laser and transmittance to AlN.
FIG. 6 is an optical photomicrograph of a laser mark formed in Example.
FIG. 7 is a cross-sectional TEM image of a laser mark formed in Example.
FIG. 8 is a schematic cross-sectional view illustrating an example of a nitride semiconductor wafer capable of laser marking of the present invention.
FIG. 9 is a schematic cross-sectional view illustrating another example of a nitride semiconductor wafer capable of laser marking of the present invention.
FIG. 10 is an optical photomicrograph of a laser mark formed in Comparative Example 1.
FIG. 11 is a cross-sectional TEM image of a laser mark formed in Comparative Example 1.
FIG. 12 is an optical photomicrograph of a laser mark formed around a pyramid defect in Comparative Example 2.
FIG. 13 is an optical photomicrograph of a laser mark formed around a crack in Comparative Example 2.
FIG. 14 is a cross-sectional TEM image of a laser mark formed in Comparative Example 2.
FIG. 15 is an optical photomicrograph of a laser mark formed in Comparative Example 3.
FIG. 16 is a graph showing a result of an electric characteristics evaluation at a location where a laser mark is formed in Example.

### DESCRIPTION OF EMBODIMENTS

As aforementioned, a pyramidal defect may be observed when a GaN epitaxial growth is performed on a single crystal silicon substrate. Such a pyramid defect may cause defocusing in the photolithography process during the device-producing process, resulting in a defect that cannot guarantee reliability after the device production.

In addition, a buffer layer that is usually formed during a GaN epitaxial growth on a single-crystal silicon substrate is similarly defective when there is an internal crack that is formed by the crack of the buffer layer during the growth.

As a measure to meet this issue, it is possible to perform marking by laser to the defect region such as a pyramid defect and an internal crack and thereby to remove a chip that has a defect region during a device-producing process at a device manufacturer or other party, thus preventing an outflow of a rejectable chip to a market.

For a typical laser marking on a semiconductor, the laser having a wavelength of larger energy than a band gap of the semiconductor is used for the laser marking. Consequently, for a substrate on which a nitride semiconductor including GaN is epitaxially grown on a single-crystal silicon substrate, marking is performed generally by irradiating a high-energy laser such as 266 nm, because the wavelength corresponding to the band gap energy of GaN is 365 nm. In this case, the surface of GaN absorbs the laser and melts for marking. However, such a case without a formation of leakage path is unable to remove a chip having a defect region by the electric characteristics evaluation in the device production process.

In addition, when a laser having a wavelength of lower energy than the band gap of GaN is irradiated, the laser is transmitted through the nitride semiconductor. Then, the single-crystal silicon substrate absorbs the laser and is melted, thus the surface of the nitride semiconductor is not marked.

To solve the above problem, the present inventors have earnestly studied and found the wafer marking method that can mark the defect region and then remove the chip having the defect region by the electric characteristics evaluation in the device production process. The method irradiates the defect region with the laser of a wavelength corresponding to the band gap energy of GaN within ±10% (±10% of 365 nm), thus the surface of the GaN layer and the surface of the single-crystal silicon substrate are marked simultaneously. Then, the leakage path is formed in the vicinity of the surface on the single-crystal silicon substrate, consequently, the chip having the defect region can be removed through the electric characteristics evaluation. Thus, the present invention has been completed.

Hereinafter, an inventive wafer marking method of the present invention will be described with reference to the drawings. However, the undermentioned structure of a nitride semiconductor substrate is just an example, and the present invention is not limited thereto.

The present invention is a wafer marking method by using a laser for performing a laser marking on a defect region of a nitride semiconductor substrate in which a nitride semiconductor layer contains at least a GaN layer formed by epitaxial growth on a single-crystal silicon substrate, wherein a surface of the GaN layer and a surface of the single-crystal silicon substrate are performed laser marking simultaneously by irradiating the defect region with a laser of a wavelength within ±10% of 365 nm, having a wavelength corresponding to a band gap energy of GaN.

Moreover, the inventive wafer marking method can produce the nitride semiconductor substrate laser marked on the defect region. In this case, this nitride semiconductor substrate has the epitaxial layer made of the nitride semiconductor layer containing at least the GaN layer on the single-crystal silicon substrate, in which a defect region of the nitride semiconductor substrate is laser marked. This substrate also has the laser mark provided at the surface of the GaN layer and the surface of the single-crystal silicon substrate at an identical location in a plane, and a leakage path is formed at the laser-marked location on the single-crystal silicon substrate.

As described above, the target of the laser marking method of the present invention is the nitride semiconductor substrate on which the nitride semiconductor layer including at least the GaN layer is formed by epitaxial growth on single-crystal silicon substrate. The nitride semiconductor substrate, as the target of the laser marking method of the present invention, may include not only the GaN layer but also an AlN layer or an AlGaN layer as the nitride semiconductor layer. In particular, the present invention is applicable to the nitride semiconductor substrate having the nitride semiconductor layer including the AlN layer and the AlGaN layer in addition to the GaN layer.

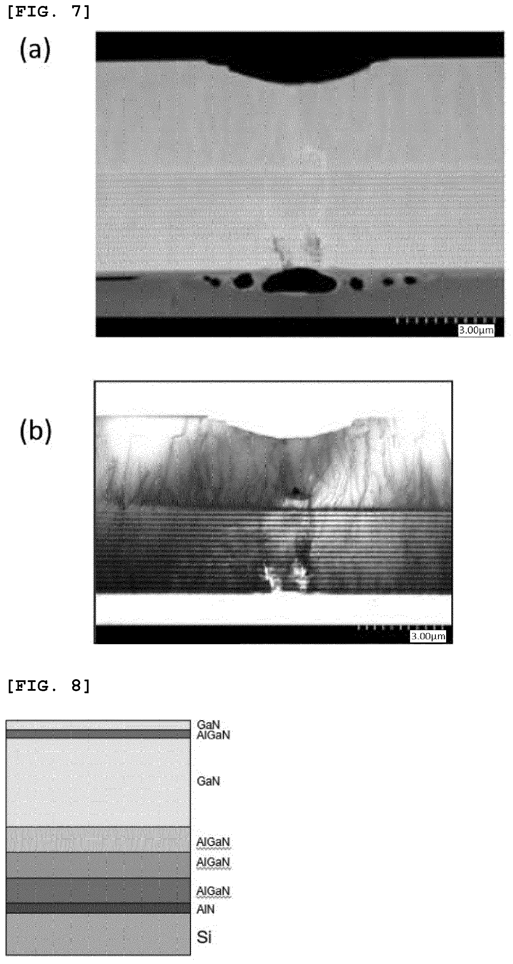

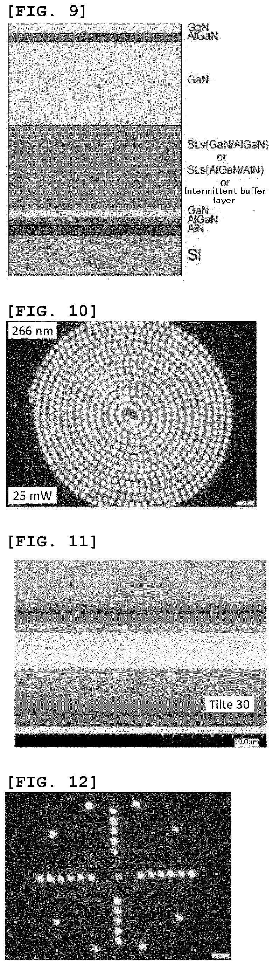

FIG. 8 and FIG. 9 show examples of the nitride semiconductor substrates capable of laser marking of the present invention. FIG. 8 shows an AlGaN layer formed as an intermediate layer on a single-crystal silicon substrate, in which the AlGaN layer has a graded buffer structure that gradually lowers the composition of Al to, for example, 50%, 25%, and 10%. Then a GaN layer, an AlGaN layer, and a GaN layer are formed on top of the AlGaN layer as device layers in that order. FIG. 9 shows a superlattice structure (SLs) or an intermittent superlattice buffer structure in which the intermediate layers are alternately stacked with the GaN layer and the AlGaN layer, or the AlN layer and the AlGaN layer.

The defect such as a pyramid defect or a crack in the nitride semiconductor substrate, in which the nitride semiconductor including the GaN layer is formed by epitaxial growth on the single-crystal silicon substrate, is detected by microscopy or other means, and the defect is marked by the laser irradiation in the vicinity of them. This laser wavelength is a wavelength within 365 nm ±10% (i.e., 328.5 to 401.5 nm). Moreover, the wavelength is preferably a wavelength within 365 nm ±5% (i.e., 346.75 to 383.25 nm). By irradiating the laser with such a wavelength, the surface of the GaN layer and the surface of the single-crystal silicon substrate can be marked simultaneously, as shown in FIG. 6, FIG. 7(a) and FIG. 7(b) in the Examples as described below. In this way, by marking the surface of the single-crystal silicon substrate (an interface with the nitride semiconductor layer), the leakage path can be formed in the vicinity of the interface. The formation of the leakage path enables the electric characteristics evaluation to detect the defect region. Consequently, a rejectable chip can be removed during a device production process easily, thus the producibility of the nitride semiconductor device can be improved and that cost can be lowered.

In other words, in the method of producing the nitride semiconductor device on the nitride semiconductor substrate, the laser mark is first applied to the defect region on the nitride semiconductor substrate according to the inventive wafer marking method. Then, in a device-producing process at a device manufacturer or other party, for example, a plurality of nitride semiconductor devices is produced on the nitride semiconductor substrate which is laser marked in this manner. Performing the electric characteristics evaluation and detecting the leakage path in the nitride semiconductor substrate, on which a plurality of nitride semiconductor devices has been produced, enables finding the nitride semiconductor device having the defect region swiftly and easily, and exclude a rejectable nitride semiconductor device.

Incidentally, the wavelength of 365 nm is the wavelength corresponding to the band gap energy of GaN, as described above. AlN and AlGaN have a larger band gap energy than that of GaN and thus a laser having a wavelength corresponding to the band gap energy of GaN can transmit through the AlN layer as well as AlGaN layer and melt the surface and a vicinity area on the single-crystal silicon. Thus, the present invention is applicable to the nitride semiconductor layer made of not only the GaN layer but also the layers containing the AlN layer as well as the AlGaN layer.

### EXAMPLE

Hereinafter, the present invention will be specifically described with reference to Examples and Comparative Examples. However, the present invention is not limited thereto.

### (Example)

A nitride semiconductor substrate was prepared by epitaxially growing a nitride semiconductor with an intermittent buffer layer having a total thickness of 6.5 um on a single-crystal silicon substrate as shown in FIG. 9. A pyramid defect on a surface of this nitride semiconductor substrate was detected by using an optical microscope, and then a marking to the defect region was performed by irradiating a surface of a GaN layer with a laser having a wavelength of the same energy as a band gap of GaN (an absorption edge 365 nm) by using a laser maker from PHOTONIC INSTRUMENTS Co.Ltd.

As a result, the surface of the substrate observed by an optical microscope is shown in FIG. 6. In addition, a cross-sectional TEM image is shown in FIG. 7(a), moreover, a detailed cross-sectional image is shown in FIG. 7(b). As FIG. 7 indicates a laser light was absorbed on a surface of an epitaxial layer, and the surface melted and became a pit, and then a dislocation stopped below the lowest part of the pit. Incidentally, the surface had no scattered objects due to a fume. Moreover, the laser beam transmitted through the epitaxial layer melted in the vicinity of an interface between the single-crystal silicon substrate and the buffer layer and then formed a gap. Furthermore, two white gaps were located from the lower portion of the buffer layer toward the top portion, and a dislocation extended upward from the white gap on the right side and stopped at the GaN layer. Besides, the area around the interface between the single-crystal silicon substrate and the buffer layer melted and vaporized, a crack was formed in part of the buffer layer and a leakage path was formed.

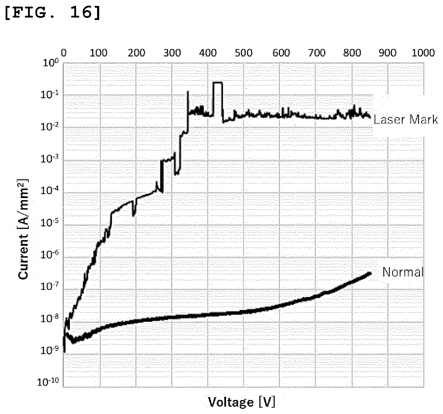

By this means, the marked wafer was sent to the device processing step to produce a square-shaped nitride semiconductor device (chip) with 300 um per side (electrode Al/Ti), and the electrical characteristics were evaluated (vertical withstand voltage measurement). The characteristics of laser-marked chip is shown in FIG. 16 as "Laser Mark" where a leakage current was generated at low voltage, and the electrical characteristics evaluation confirmed that the chip were defective immediately. The normal area without the laser mark shows no leakage current, as shown in FIG. 16 as "Normal".

### (Comparative Example 1)

A nitride semiconductor substrate was prepared by epitaxially growing a nitride semiconductor with an intermittent buffer layer having a total thickness of 6.5 um on a single-crystal silicon substrate as shown in FIG. 9. A laser marking was performed under the same condition as in the Example except that a laser marker from TAKANO CO., LTD. (25 mW) was used to irradiate the surface of the epitaxial layer at a wavelength of 266 nm, which had higher energy than the band gap of GaN, in numerous spiral patterns.

As a result, a state on the surface of the substrate observed by the optical microscope is shown in FIG. 10, and the cross-sectional TEM image is shown in FIG. 11. The wavelength of 266 nm has very low transmittance for GaN. For this reason, as FIG. 11 shows, the surface of the wafer (the surface of the GaN layer) absorbed the laser and the surface was melted, resulting in marking. No laser mark was formed on the surface of the silicon substrate. In addition, no fume was scattered around the laser mark, thus neat marking was achieved. Moreover, a surface and cross-sectional observation of the cross-sectional TEM image indicated mere a formation of a shallow pit on the surface, but no significant changes were observed in the epitaxial layer.

Furthermore, as in Example, the marked wafer was sent to the device processing step and further was evaluated for the electrical characteristics. As a result, the leakage path portion was not formed at the laser-marked location on the single crystal silicon substrate, and the nitride semiconductor device having the defect region was not detected by the electric characteristics evaluation.

### (Comparative Example 2)

To begin with, a nitride semiconductor substrate was prepared by epitaxially growing a nitride semiconductor with an intermittent buffer layer having a total thickness of 6.5 um on a single-crystal silicon substrate as shown in FIG. 9. A laser marking was performed under the same conditions as in the Example, except that the epitaxial layer surface around a pyramid defect and a crack were laser-irradiated with a laser at a wavelength of 435 nm, which has lower energy than a band gap of GaN, using a laser marker from PHOTONIC INSTRUMENTS Co.Ltd.

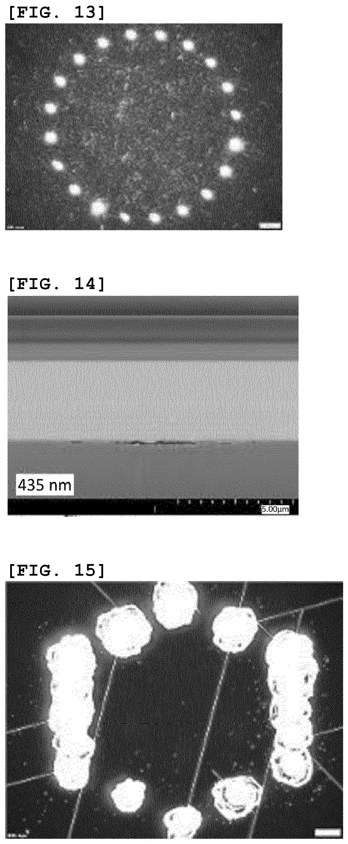

As a result, the state on the surface of the substrate observed by an optical microscope is shown in FIG. 12 (A pyramid defect is the center of an image), and FIG. 13 (a crack is observable in the place encircled by a ring-shaped laser mark). Additionally, the cross-sectional TEM image is shown in FIG. 14. As can be seen from these FIGS., with the laser having a wavelength of 435 nm, which has lower energy than the band gap of GaN, there was no trace of melting on the surface of the epitaxial layer and light with a wavelength longer than the absorption edge of GaN transmitted through as per the physical principle. In addition, the single-crystal silicon substrate absorbed the laser light and melted, creating a void. The surface of the GaN layer was not laser marked. The laser mark visible in FIG. 12 and FIG. 13 is the laser mark on the single-crystal silicon substrate, which can be seen through.

### (Comparative Example 3)

A nitride semiconductor substrate was prepared by epitaxially growing a nitride semiconductor with an intermittent buffer layer having a total thickness of 6.5 um on a single-crystal silicon substrate as shown in FIG. 9. A laser marking was performed under the same condition as in the Example except that a laser marker from Miyachi Technos Corp. was used to perform laser marking at a wavelength of 532 nm, which had lower energy than the band gap of GaN.

As a result, as shown in FIG. 15, it transmitted the GaN layer and was absorbed, and melted the surface of the single-crystal silicon substrate, causing a burst due to vapor pressure as well as marking. On this occasion, the fume scattered around the marking, and the epitaxial layer was rolled up and was floating due to bursting. The fume baked on was irremovable even when cleaned. The state of the marking could be observed by the optical microscope alone. The scatter of the fume will be problematic in the device production.

It should be noted that the present invention is not limited to the above-described embodiments. The embodiments are just examples, and any examples that have substantially the same features and demonstrate the same functions and effects as those in the technical concept disclosed in claims of the present invention are included in the technical scope of the present invention.

## Claims

1. A wafer marking method by using a laser for performing a laser marking on a defect region of a nitride semiconductor substrate in which a nitride semiconductor layer contains at least a GaN layer formed by epitaxial growth on a single-crystal silicon substrate, wherein
a surface of the GaN layer and a surface of the single-crystal silicon substrate are performed laser marking simultaneously by irradiating the defect region with a laser of a wavelength within ±10% of 365 nm, having a wavelength corresponding to a band gap energy of GaN.

2. The wafer marking method according to claim 1, wherein
a wavelength of the laser performing the marking is ±5% of 365 nm.

3. The wafer marking method according to claim 1 or 2, wherein
the nitride semiconductor layer includes an AlN layer and an AlGaN layer in addition to the GaN layer.

4. A method of producing a nitride semiconductor device on a nitride semiconductor substrate comprising the steps of:
performing a laser marking on the nitride semiconductor substrate by the wafer marking method according to any one of claims 1 to 3;
producing a plurality of nitride semiconductor devices on the laser-marked nitride semiconductor substrate; and
evaluating electrical characteristics of the nitride semiconductor substrate with a plurality of nitride semiconductor devices being produced then removing a nitride semiconductor device having the defect region by detecting a leakage path.

5. A nitride semiconductor substrate having an epitaxial layer made of a nitride semiconductor layer containing at least a GaN layer on a single-crystal silicon substrate, in which a defect region of the nitride semiconductor substrate is laser marked, wherein
the laser mark is provided at a surface of the GaN layer and a surface of the single-crystal silicon substrate at an identical location in a plane, and a leakage path is formed at the laser-marked location on the single-crystal silicon substrate.

6. A method of producing a nitride semiconductor device on a nitride semiconductor substrate comprising the steps of:
producing a plurality of nitride semiconductor devices on the nitride semiconductor substrate according to claim 5; and
evaluating electrical characteristics of the nitride semiconductor substrate with a plurality of nitride semiconductor devices being produced then removing a nitride semiconductor device having the defect region by detecting a leakage path.
